# FASCICULE DE BREVET EUROPEEN

(11) **EP 4 156 438 B1**
(45) Date de publication et mention de la délivrance du brevet: **26.06.2024**
(21) Numéro de dépôt: 22305033.7
(22) Date de dépôt: 14.01.2022
(51) Int. Cl.: H02J 3/06

(54) **SYSTÈME DE DISTRIBUTION D'ÉLECTRICITÉ POUR UNE INSTALLATION DOMESTIQUE COMPRENANT PLUSIEURS SOURCES ÉLECTRIQUES**
STROMVERTEILUNGSSYSTEM FÜR EINE HEIMANLAGE MIT MEHREREN STROMQUELLEN
ELECTRICITY DISTRIBUTION SYSTEM FOR A HOUSEHOLD INSTALLATION COMPRISING A PLURALITY OF ELECTRICAL SOURCES

(30) Priorité: 24.09.2021 FR 2110100
(43) Date de publication de la demande: 29.03.2023
(73) Titulaire: Schneider Electric Industries SAS, 92500 Rueil-Malmaison (FR)
(72) Inventeur: LEBEAU, Bernard, 38190 LES ADRETS (FR); DU PORT DE PONCHARRA, Etienne, 38570 CREST EN BELLEDONNE (FR); BUR, Emmanuel, 38500 LA BUISSE (FR)
(74) Mandataire: Lavoix

(56) Documents cités:
- WO-A1-2018/234330
- US-A1- 2021 083 506

## Description

### DOMAINE TECHNIQUE

L'invention concerne un système de distribution d'électricité pour une installation domestique. L'invention concerne également un procédé de gestion d'un tel système de distribution d'électricité.

### ETAT DE LA TECHNIQUE ANTERIEURE

De nos jours, il est courant que des installations domestiques de distribution d'électricité soient alimentées par plusieurs sources électriques, par exemple par un réseau public de distribution (« grid » en anglais) et par une source d'alimentation locale, tel qu'un ou plusieurs générateurs photovoltaïques (PV).

Souvent, les sources d'alimentation locales sont branchées sur des installations de distribution existantes. C'est par exemple le cas lorsque des générateurs photovoltaïques sont posés sur une habitation déjà pourvue d'une installation de distribution.

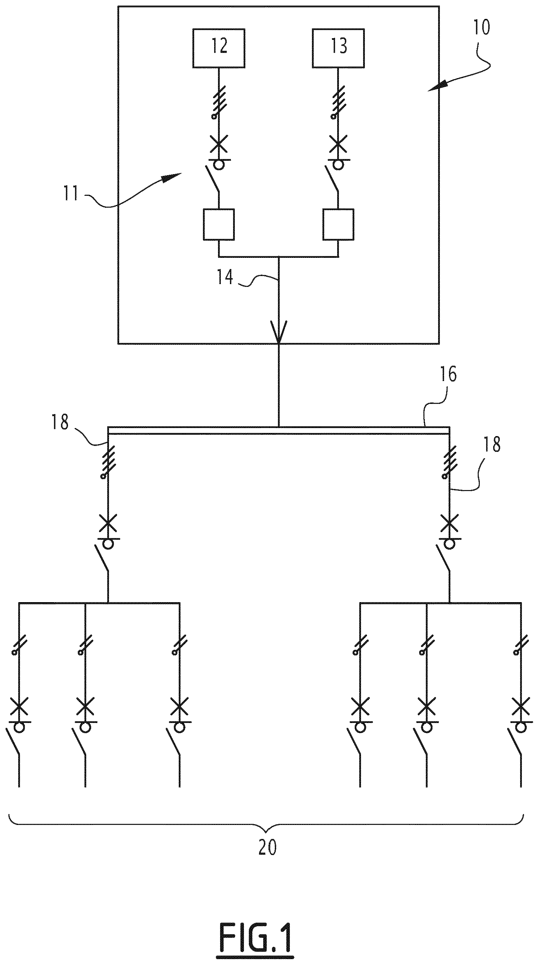

Pour des raisons de coût et de facilité d'installation, il est fréquent que ces sources d'alimentation locales soient branchées en amont de l'installation de distribution, aux côtés de l'arrivée du réseau public de distribution, et en aval du disjoncteur principal 11 (figure 1).

Dans ce cas, le disjoncteur principal 11 est incapable de protéger l'installation locale dans le cas où le courant électrique total (I_total) égal à la somme du courant issu du réseau (I_grid) et du courant issu de la source locale (I_PV) serait supérieur à un seuil de sécurité I_seuil (par exemple 63 Ampères) lorsque les deux sources génèrent de l'électricité qui est consommée par les charges de l'installation domestique, puisque le disjoncteur principal 11 n'est pas situé sur la même branche de l'installation que la source d'alimentation locale.

De plus, dans de nombreux cas, les installations domestiques ne sont généralement pas prévues pour alimenter des charges de forte puissance pendant de longues durées, ce qui aggrave le risque de surcharge de l'installation.

La figure 1 représente un exemple d'une telle configuration, dans laquelle une installation domestique de distribution d'électricité 10 est configurée pour être alimentée par un réseau public de distribution 12 et par des générateurs photovoltaïques 13, ces deux sources d'alimentation étant raccordés par un branchement commun 14 à une entrée d'un même répartiteur 16. La sortie du répartiteur 16 est connectée à des conducteurs 18 qui alimentent une pluralité de charges électriques domestiques 20.

Avec une telle configuration, le disjoncteur principal 11 peut ne pas se déclencher lorsque le courant total (I_total) est supérieur au seuil de sécurité I_seuil (courant maximum admissible par le tableau, en particulier au niveau du noeud 14) alors que le courant issu du réseau (I_grid) reste inférieur au seuil de déclenchement du disjoncteur principal 11.

Une telle situation peut créer de graves problèmes de sécurité, tels qu'un risque d'incendie, et doit donc être évitée.

Le document US 2021/083596 A1 décrit un système de gestion de charges électriques comprenant une pluralité de circuits de dérivation.

Il existe un besoin pour une installation électrique domestique permettant de connecter facilement une ou plusieurs sources d'alimentation secondaires aux côtés de l'arrivée du réseau d'alimentation, sans compromettre la sécurité de l'installation.

En particulier, l'installation doit être facile à mettre en oeuvre, de manière à pouvoir être facilement installée par des électriciens sans avoir besoin de construire des tableaux de distributions complexes et nécessitant une quantité importante de connecteurs et de fils de raccordement, qui sont longs et coûteux à mettre en oeuvre.

### RESUME DE L'INVENTION

À cet effet, un aspect de l'invention concerne un système de distribution électrique pour distribuer des courants électriques entre un réseau de distribution électrique et une installation domestique de distribution, dans lequel le système comporte :
- un appareil de commutation électrique multi sources configuré pour commuter entre deux états autorisant ou empêchant respectivement la circulation de courants électriques dans deux chemins de conduction électrique comportant chacun une pluralité de conducteurs électriques ;
- un dispositif de raccordement électrique raccordé en sortie de l'appareil de commutation électrique, le dispositif de raccordement étant configuré pour prolonger les deux chemins de conduction électrique en sortie de l'appareil de commutation ;

dans lequel l'appareil de commutation électrique est configuré pour connecter, sur une première entrée, un premier des deux chemins de conduction électrique à un réseau de distribution électrique, l'appareil de commutation électrique est configuré pour connecter, sur sa deuxième entrée, le deuxième des deux chemins de conduction électrique à une source électrique auxiliaire ;
dans lequel le dispositif de raccordement est configuré pour connecter chaque chemin de conduction électrique à une ou plusieurs charges électriques en sortie de l'appareil de commutation électrique, et
dans lequel le dispositif de raccordement comporte un point d'interconnexion dans lequel les conducteurs électriques correspondants de chaque chemin de conduction électrique sont connectés entre eux, l'appareil de commutation électrique multi-sources formant un point de déconnexion unique capable de déconnecter simultanément du reste du réseau de distribution électrique les sources électriques connectées à la première entrée et à la deuxième entrée.

Selon des aspects avantageux mais non obligatoires, un tel système peut incorporer une ou plusieurs des caractéristiques suivantes, prises isolément ou suivant toute combinaison techniquement admissible :
- Le dispositif de raccordement électrique forme un pont en H pour chaque phase électrique ou ligne de neutre.
- Le dispositif de raccordement électrique comporte des conducteurs de connexion en un matériau électriquement conducteur, chaque conducteur de connexion étant associée à une phase électrique ou à une ligne de neutre.
- Le dispositif de raccordement électrique comporte, pour chaque phase électrique ou ligne de neutre, un ensemble de conducteurs électriques comportant :
   - au moins un premier conducteur pour former le premier chemin de conduction électrique associé à cette phase ou ligne de neutre,
   - au moins un deuxième conducteur pour former le deuxième chemin de conduction électrique associé à cette phase ou ligne de neutre, et
   - un point d'interconnexion associé à cette phase ou ligne de neutre qui raccorde le au moins un premier conducteur audit au moins un deuxième conducteur de cette phase ou ligne de neutre.
- Chaque point d'interconnexion du dispositif de raccordement électrique a un calibre de 63 Ampères.
- Chaque point d'interconnexion du dispositif de raccordement électrique a un calibre de 125 Ampères.
- Chacun du premier chemin de conduction électrique et du deuxième chemin de conduction électrique du dispositif de raccordement électrique a un calibre de 63 Ampères.
- Une partie des charges électriques est apte à être connectée au premier chemin de conduction électrique et une autre partie des charges électriques est apte à être connectée au deuxième chemin de conduction électrique.
- La source électrique auxiliaire comporte un ou plusieurs générateurs photovoltaïques.

L'invention concerne aussi une installation comportant une installation de distribution électrique, notamment à usage domestique, comportant un système de distribution électrique tel que défini précédemment.

### BREVE DESCRIPTION DES FIGURES

L'invention sera mieux comprise et d'autres avantages de celle-ci apparaîtront plus clairement à la lumière de la description qui va suivre d'un mode de réalisation d'un système donné uniquement à titre d'exemple et faite en référence aux dessins annexés, dans lesquels :
- la figure 1 représente schématiquement une installation électrique selon l'état de la technique ;
- la figure 2 représente schématiquement une installation électrique comprenant un système de distribution électrique conforme à l'invention ;
- la figure 3 représente schématiquement le système de distribution électrique de la figure 2 ;
- la figure 4 représente schématiquement un procédé de fonctionnement de l'installation électrique de la figure 2 ;
- la figure 5 représente schématiquement une partie des étapes du procédé de fonctionnement de la figure 4 ;
- la figure 6 représente schématiquement une partie des étapes du procédé de fonctionnement de la figure 4, et
- la figure 7 représente schématiquement une partie des étapes du procédé de fonctionnement de la figure 4.

### DESCRIPTION DETAILLEE DE MODES DE REALISATION DE L'INVENTION

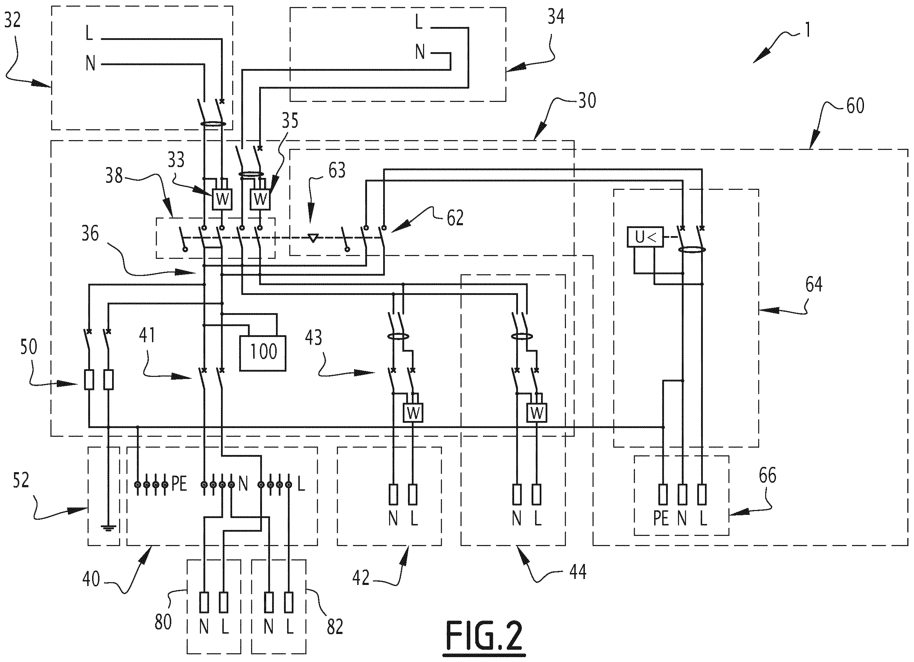

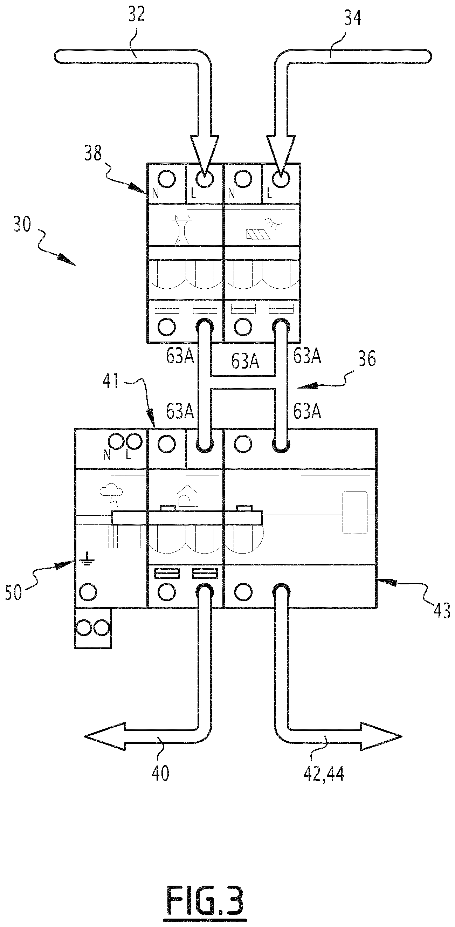

La figure 2 et la figure 3 représentent un mode de réalisation conforme à l'invention d'un système de distribution d'électricité 30 pour une installation domestique 1.

Dans de nombreux modes de réalisation, au moins une partie des constituants du système 30 sont logés dans un tableau électrique, ce dernier pouvant être au moins en partie installé dans un tableau électrique (par exemple un tableau mural) ou dans une armoire électrique.

Le système est configuré pour être alimenté par un réseau de distribution électrique 32 (secteur, ou « grid » en anglais) et par au moins une source d'alimentation secondaire 34. Le nombre et la nature des sources d'alimentation électrique secondaires 34 peut être différent selon les modes de réalisation possibles.

De préférence, au moins une source d'alimentation électrique secondaire 34 (ou générateur secondaire) comporte des panneaux photovoltaïques (PV). L'installation peut ainsi comporter un ou plusieurs générateurs photovoltaïques agissant en tant que source d'alimentation électrique secondaire aux côtés du réseau 32. Au moins une source d'alimentation électrique secondaire 34 pourrait comporter un système de stockage d'électricité sur batterie « dimmable » pouvant être source ou charge.

Le système 30 comporte ici un point de raccordement comportant des bornes de raccordement destinées à être connectées au réseau 32. Selon les modes de réalisation, il peut s'agir d'un point de raccordement monophasé ou polyphasé (par exemple triphasé) avec ou sans ligne de neutre.

Par exemple, entre le système 30 et le réseau 32 (appelé « Grid » en anglais) se trouve un élément de protection, qui peut comporter un appareil de protection électrique, tel qu'un disjoncteur ou un fusible ou un compteur d'énergie à limitation de puissance, par exemple. Dans l'exemple illustré, l'élément de protection comporte un disjoncteur, dit disjoncteur principal, qui correspond au disjoncteur principal 11 décrit en référence à la figure 1.

On comprend donc que la contrainte visant à surveiller voire limiter le courant circulant au travers de cet élément de protection pour ne pas dépasser le seuil de déclenchement I_seuil, peut être généralisée au cas où l'élément de protection est autre chose qu'un disjoncteur. Il s'agit alors, par exemple, de ne pas dépasser un courant qui pourrait conduire à l'endommagement d'un conducteur électrique de l'élément de protection.

Le système 30 comporte également un dispositif de raccordement 36 électrique et un appareil de commutation électrique multi sources 38.

L'appareil de commutation 38 est configuré pour commuter entre deux états, fermé et ouvert, autorisant ou empêchant respectivement la circulation de courants électriques dans deux chemins de conduction électrique comportant chacun une pluralité de conducteurs électriques.

Le nombre de chemins de conduction électrique dépend du nombre de phases électriques dans l'installation électrique 1, et donc pour chaque entrée et pour chaque sortie de l'appareil de commutation 38.

Dans l'exemple illustré, l'installation électrique 1 est une installation monophasée avec neutre. Chaque liaison électrique comporte un conducteur de phase (noté L) et un conducteur de neutre (noté N). De même, comme visible sur la figure 2, chaque source électrique et chaque charge électrique comporte un connecteur de phase (L) et un connecteur de neutre (N). Dans certains cas, des charges électriques peuvent comporter en plus un connecteur de mise à la terre (noté PE).

Dans cet exemple, il y a donc deux conducteurs (de neutre N et de phase L) pour chaque chemin de conduction.

En variante, le nombre de phases pourrait être différent. Par exemple, l'installation électrique 1 pourrait être une installation triphasée avec neutre (quatre conducteurs), ou une installation triphasée sans neutre (trois conducteurs). Le nombre de conducteurs par liaison électrique est alors adapté en conséquence.

Dans de nombreux modes de réalisation, l'appareil de commutation 38 est un disjoncteur, ou un contacteur, ou un relais, ou un interrupteur, ou tout appareil de commutation équivalent. Il peut s'agir d'un appareil électromécanique, ou un appareil à semi-conducteurs, ou un appareil hybride mêlant interrupteurs à semi-conducteurs et interrupteurs électromécaniques, ou tout appareillage équivalent.

L'appareil de commutation 38 est apte à être raccordé à plusieurs sources électriques indépendantes et à plusieurs charges indépendantes, chaque paire de source et de charge étant associée à un chemin de conduction électrique, mais la commutation entre l'état ouvert ou l'état fermé est faite simultanément pour tous les chemins de conduction électrique.

Par exemple, l'appareil de commutation 38 comporte une première entrée et une deuxième entrée distinctes l'une de l'autre. Chaque entrée comporte ici deux conducteurs électriques (un pour la phase L et un pour le neutre N), mais ce nombre pourrait être différent en variante selon le nombre de phases dans l'installation 1.

L'appareil de commutation 38 connecte, sur une première entrée, le premier des deux chemins de conduction électrique au réseau de distribution électrique 32. L'appareil de commutation électrique connecte, sur sa deuxième entrée, le deuxième des deux chemins de conduction électrique à la source électrique auxiliaire 34.

Le dispositif de raccordement 36 est agencé pour distribuer un courant électrique dans l'installation, à la manière d'un répartiteur.

Plus précisément, le dispositif de raccordement 36 est connecté en sortie de l'appareil de commutation électrique 38 et est configuré pour prolonger les deux chemins de conduction électrique en sortie de l'appareil de commutation pour connecter chaque chemin de conduction électrique à une ou plusieurs charges électriques 40, 42, 44 en sortie de l'appareil de commutation électrique 38. En d'autres termes, le système 30 est configuré pour être connecté, côté aval, à une pluralité de charges électriques.

Par exemple, une partie des charges électriques 40 est connectée au premier chemin de conduction électrique et une autre partie des charges électriques 42, 44 est connectée au deuxième chemin de conduction électrique.

Le dispositif de raccordement 36 est ainsi apte à alimenter électriquement les charges électriques, en transférant au moins une partie du courant électrique généré par une ou par plusieurs des sources électriques 32, 34 connectées en amont. Ces sources principales sont ici connectées en parallèle.

Sur la figure 2, les charges électriques correspondent aux références 40, 42 et 44, étant entendu que cet exemple n'est pas limitatif et qu'un nombre différent de charges électriques peut être prévu en variante.

Dans de nombreux modes de réalisation, parmi ces charges électriques, deux types de charges électriques peuvent être distinguées : des charges électriques dites critiques (ou charges principales) et des charges électriques domestiques (ou charges secondaires).

Par exemple, les charges électriques principales 42 et 44 correspondent à des charges électriques susceptibles de consommer des puissances électriques importantes (par rapport à des charges électriques domestiques ordinaires) et/ou de consommer des courants électriques d'intensité électrique élevée, et/ou d'être actives en continu pendant de longues durées (par exemple pendant plus de 10 heures).

Par exemple, les charges électriques principales comportent un véhicule électrique ou une station de charge d'un véhicule électrique. Dans des variantes non illustrées, ces charges pourraient comporter un chauffe-eau, ou une pompe à chaleur (ou climatiseur, ou plus généralement une installation de chauffage domestique), ou un climatiseur ou un système de chauffage de piscine.

Par comparaison, les charges électriques domestiques consomment une puissance électrique moindre et leur fonctionnement est généralement intermittent. Par exemple, les charges électriques domestiques sont des éléments d'éclairage, ou des appareils domestiques branchés sur des prises électriques domestiques, tels que des appareils électroménagers, des appareils multimédia, des équipements informatiques, des luminaires, ces exemples n'étant pas limitatifs. Les charges électriques domestiques sont généralement connectées sur un tableau électrique domestique 40. Ce tableau électrique domestique 40 peut, par exemple, être un tableau classique domestique limité à 63 A.

Deux charges électriques domestiques 80 et 82 sont illustrées sur l'exemple de la figure 2. Par exemple, la première charge domestique 80 est un chauffe-eau tandis que la deuxième charge domestique 82 est une pompe à chaleur.

En pratique, chacune desdites charges électriques 80, 82, 42 et 44 est raccordée au dispositif de raccordement 36 par l'intermédiaire de conducteurs électriques (ou de plusieurs conducteurs de phase et/ou de neutre, selon la nature de l'installation électrique).

Les charges électriques secondaires 80 et 82, dont les bornes de connexion sont généralement rassemblées dans un coffret secondaire, contenant le tableau 40, sont par exemple raccordées à la première sortie du dispositif de raccordement 36 par une ligne électrique protégée par un disjoncteur 41 dont le calibre est dimensionné pour ne pas dépasser le courant maximal admissible du coffret secondaire, par exemple 63 Ampères.

Les charges électriques principales 42, 44, sont par exemple raccordées à la deuxième sortie du dispositif de raccordement 36 par une ligne électrique protégée par un appareil de protection 43, tel qu'un disjoncteur et/ou un appareil de protection différentielle, dont le calibre est dimensionné pour ne pas dépasser le courant maximal, par exemple 63 Ampères.

Dans de nombreux modes de réalisation, comme visible schématiquement sur les figures 2 et 3, le dispositif de raccordement 36 comporte une pluralité de conducteurs électriques de connexion, tels que des barres de connexion, ou des rails de connexion, ou encore des câbles de connexion, pour chaque phase électrique (ou ligne de neutre).

Notamment, le dispositif de raccordement 36 comporte un point d'interconnexion dans lequel les conducteurs électriques (L, N) correspondants de chaque chemin de conduction électrique sont connectés entre eux.

Par exemple, un premier ensemble de conducteurs électriques est associé à la phase L. Ce premier ensemble comporte au moins un premier conducteur pour former le premier chemin de conduction électrique associé à la phase L et au moins un deuxième conducteur pour former le deuxième chemin de conduction électrique associé à la phase L. Ce premier ensemble comprend également un point d'interconnexion associé à la phase L qui raccorde le au moins un premier conducteur audit au moins un deuxième conducteur. Ainsi, les conducteurs formant le premier chemin de conduction et le deuxième chemin de conduction de la phase L sont raccordés entre eux

De même, un deuxième ensemble de conducteurs électriques est associé au neutre N. Ce deuxième ensemble comporte au moins un premier conducteur pour former le premier chemin de conduction électrique associé au neutre N et au moins un deuxième conducteur pour former le deuxième chemin de conduction électrique associé au neutre N. Ce deuxième ensemble comprend également un point d'interconnexion associé au neutre N qui raccorde le au moins un premier conducteur audit au moins un deuxième conducteur. Ainsi, les conducteurs formant le premier chemin de conduction et le deuxième chemin de conduction du neutre N sont raccordés entre eux.

Cependant, les conducteurs électriques du premier ensemble (associés à la phase L) ne sont pas en contact électrique avec les conducteurs électriques du deuxième ensemble (associés au neutre N) et restent électriquement isolés des conducteurs électriques du deuxième ensemble (associés au neutre N).

On comprend qu'en variante, dans un système 30 polyphasé, par exemple triphasé, cette configuration peut être généralisée pour chacune des phases électriques. On définit ainsi autant d'ensembles de conducteurs électriques (et de points d'interconnexion) qu'il y a de phases électriques.

Sur la figure 3, les conducteurs électriques du dispositif de raccordement 36 sont illustrés uniquement pour la phase électrique L. Les conducteurs électriques du dispositif de raccordement 36 correspondant au neutre N ne sont pas illustrés dans un souci de clarté.

Par exemple, pour chaque phase ou ligne de neutre, le dispositif de raccordement 36 présente une forme de pont en H, le point d'interconnexion correspondant à la branche horizontale du pont en H qui raccorde les deux autres branches du pont en H.

Avantageusement, le dispositif de raccordement électrique 36 est pré-câblé. Par exemple, les conducteurs électriques sont connectés et fixés mécaniquement et/ou montés sur un support. Le dispositif de raccordement électrique 36 peut être formé d'une seule pièce préassemblée. Les conducteurs peuvent être au moins en partie séparés par des portions isolantes, par exemple pour séparer les chemins de conduction électriques de polarités différentes.

De préférence, les conducteurs électriques du dispositif de raccordement 36 sont dimensionnés en fonction du courant maximal admissible par les charges électriques correspondantes, par exemple en étant dimensionnés au plus juste pour ne pas avoir à surdimensionner les conducteurs électriques. Cela permet d'économiser la quantité de matière utilisée et donc de réduire le coût de l'installation.

Par exemple, les conducteurs électriques associés à chaque chemin de conduction électrique ont un calibre de 63 Ampères, c'est-à-dire qu'il autorise la circulation d'un courant alternatif ou continu d'amplitude inférieure ou égale à 63 Ampères. De même, le point d'interconnexion a un calibre de 63 Ampères. Ces valeurs peuvent être différentes en variante.

De par sa conception, le dispositif de raccordement 36 permet de répartir le courant issu des sources 32 et 34 vers les charges électriques 40, 42 et 44 en fonction des besoins des charges 40, 42, 44 et de la puissance électrique délivrée par les sources 32 et 34.

Le dispositif de raccordement 36 est simple à mettre en oeuvre, par exemple plus simple que de câbler à la main les sources et les charges à des interrupteurs et à un dispositif de régulation. Le coût de fabrication du système est également réduit, puisqu'il nécessite moins de matériaux conducteurs, tels que du cuivre.

Le système 30 permet donc de gérer efficacement et simplement plusieurs sources électriques de nature différente dans une même installation de distribution électrique, notamment lorsque cette installation comporte plusieurs charges électriques de nature différente présentant des contraintes de fonctionnement différentes.

Par exemple, le système 30 permet de recevoir une puissance électrique allant jusqu'à 12 kW depuis le réseau 32, ainsi qu'une puissance électrique allant jusqu'à 12 kW depuis la ou les sources secondaires 34. Grâce au dispositif de raccordement 36 associé au dispositif de commutation 38, le système 30 peut distribuer les courants électriques correspondants entre les charges sans risquer de dépasser les limites permises pour l'installation 1, telle que le seuil de sécurité I_seuil défini ci-dessus, ou encore des limites imposées par le gestionnaire du réseau 32.

Par exemple, si une charge électrique telle qu'un véhicule électrique 42, 44 nécessite temporairement une puissance électrique plus élevée que ce que l'une ou l'autre des sources 32 et 34 peut délivrer, le point d'interconnexion du dispositif de raccordement 36 permet de transférer la puissance électrique nécessaire depuis l'autre source électrique.

Dans certains modes de réalisation, lorsque le système 30 est configuré pour être connecté à un véhicule électrique pouvant agir comme dispositif de stockage réversible d'électricité (configuration « EV to grid » en anglais), il est possible de dimensionner le dispositif de raccordement 36 pour accepter une limite de courant correspondant à la somme des courants provenant des sources locales et du véhicule électrique (« EV to grid »), c'est-à-dire une limite de 125 Ampères ou plus au niveau de l'interconnexion. Le point d'interconnexion du dispositif de raccordement 36 permet de transférer la puissance électrique nécessaire vers les sources secondaires (connectées au tableau 40, telles que les sources 80 et/ou 82) sans avoir besoin de sur solliciter les sources 32 ou 34.

Parmi les avantages du système 30, le dispositif de commutation 38 peut, de par son association au dispositif de raccordement 36, fonctionner en tant que point de déconnexion unique (ou sectionnement centralisé), permettant d'assurer la déconnexion de l'ensemble des sources 32 et 34 connectées en amont en un seul lieu et en une seule action (un seul appareil de commutation à manipuler pour le placer en position ouverte), assurant une sécurité d'intervention des personnes pour la maintenance du tableau.

Dit autrement, l'appareil de commutation 38 forme un point de déconnexion unique capable de sectionner simultanément du reste du réseau de distribution électrique 30 les sources électriques connectées à la première entrée et à la deuxième entrée.

Optionnellement, comme illustré sur les figures 2 et 3, le système 30 peut comporter un dispositif de protection contre la foudre 50. Ce dispositif de protection contre la foudre est connecté en aval du dispositif de raccordement 36. Dans l'exemple illustré, le dispositif de protection contre la foudre comporte une ou plusieurs varistances connectées entre le dispositif de raccordement 36 et un point de raccordement à la terre 52 de l'installation électrique connecté au bornier de raccordement à la terre. Par exemple, une varistance est connectée sur chaque conducteur électrique (un pour la phase L et un pour le neutre N) du premier chemin de conduction électrique en aval du dispositif de raccordement 36.

Comme illustré sur la figure 2, l'installation 1 peut optionnellement comporter une source électrique de secours 60 comportant un groupe électrogène.

Dans certains modes de réalisation, un système de stockage d'électricité, comportant par exemple un ensemble de batteries électrochimiques, pourrait être utilisé comme source de secours 60.

La source de secours 60 comporte un interrupteur sectionneur 62 inter verrouillé avec l'appareil de commutation 38 et est raccordée au dispositif de raccordement 36 (par exemple en étant raccordée à la fois aux deux chemins de conduction).

Plus précisément, la source de secours optionnelle 60 comporte un enclenchement de sécurité 63, ou dispositif de verrouillage (« interlocking » en anglais) qui permet d'inter verrouiller les sources 32 et 34 avec la source de secours 60 pour exclure l'ensemble des sources principales et secondaires lors du fonctionnement en mode secours.

Autrement dit, le dispositif 64 permet de choisir entre d'une part la source de secours 60 et d'autre part les sources principale 32 et secondaire 34 pour alimenter le dispositif de raccordement 36, en empêchant la source de secours 60 d'être connectée simultanément avec les sources principale 32 et secondaire 34.

Dans l'exemple illustré, le dispositif de verrouillage 63 est couplé mécaniquement à l'appareil de commutation 38 et à l'interrupteur sectionneur 62. Par exemple, l'interrupteur sectionneur 62 est maintenu dans l'état ouvert tant que l'appareil de commutation 38 est dans l'état fermé, et vice versa. Le dispositif de verrouillage 63 peut être de type mécanique ou électromécanique ou électronique, d'autres modes de réalisation étant néanmoins possibles.

Dans l'exemple de la figure 2, la source de secours 60 comporte, en amont de l'interrupteur sectionneur 62, un appareil de protection électrique 64 et des terminaux de connexion 66 permettant de connecter un générateur de secours ou un système de stockage d'énergie (qui n'est pas visible sur les figures).

En variante, la source de secours 60 peut être omise. Dans ce cas, le dispositif de verrouillage 63 peut être omis.

Dans des modes de réalisation optionnels mais néanmoins avantageux, le système 30 peut également comporter un dispositif électronique de commande 100, décrit ci-après, qui est configuré pour gérer automatiquement la répartition du courant électrique entre les charges électriques.

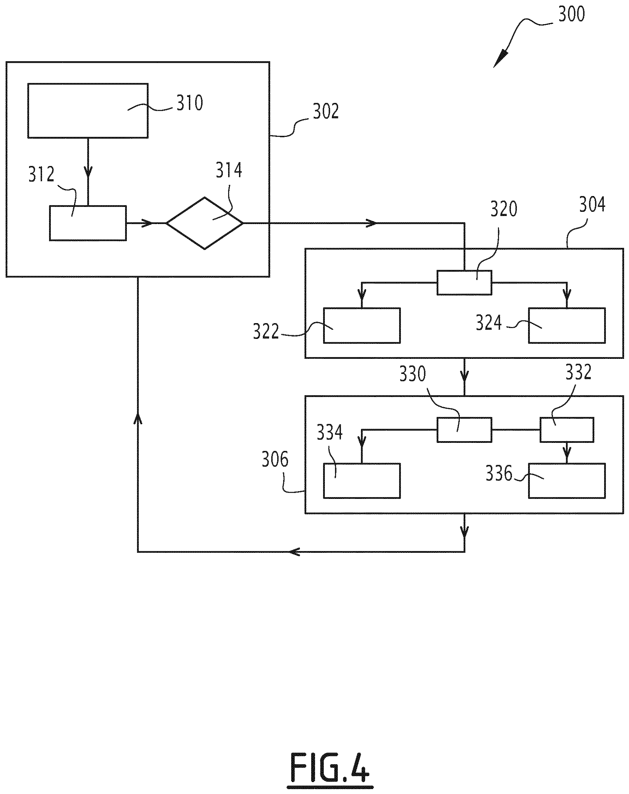

La figure 4 représente un exemple d'un procédé de gestion du système 30 pouvant être optionnellement mis en oeuvre par le dispositif électronique de commande 100.

Dans de nombreux modes de réalisation, le dispositif électronique de commande 100 est implémenté par un ou plusieurs circuits électroniques, par exemple par un contrôleur logique programmable (PLC).

Par exemple, le dispositif électronique de commande 100 comporte un processeur, tel qu'un microcontrôleur programmable ou un microprocesseur. Le processeur est couplé à une mémoire informatique, ou à tout support d'enregistrement de données lisible par ordinateur, qui comporte des instructions exécutables et/ou un code logiciel prévu pour mettre en oeuvre un procédé de gestion du système 30 qui sera décrit ci-après lorsque ces instructions sont exécutées par le processeur.

L'emploi du terme « processeur » ne fait pas obstacle à ce que, en variante, au moins une partie des fonctions du dispositif électronique de commande soient réalisées par d'autres composants électroniques, tels qu'un processeur de traitement du signal (DSP), ou un composant logique reprogrammable (FPGA), ou un circuit intégré spécialisé (ASIC), ou tout élément équivalent, ou toute combinaison de ces éléments.

Notamment, le dispositif électronique de commande 100 est configuré pour gérer des paramètres d'alimentation d'au moins une partie des charges électriques et/ou déconnecter ou reconnecter automatiquement une ou plusieurs des charges électriques en fonction du courant mesuré.

Par exemple, le dispositif électronique de commande 100 est connecté à des capteurs permettant de déterminer le courant électrique circulant dans l'installation.

De préférence, le système 30 comporte des dispositifs pour mesurer des grandeurs électriques, telles que le courant et/ou la tension électrique et/ou la puissance électrique, associés aux charges électriques (au moins pour les charges principales) et aux sources électriques. Ces dispositifs de mesure peuvent comporter des capteurs de courant et/ou des capteurs de tension ou tout autre appareil de mesure approprié.

Le dispositif électronique de commande 100 est également connecté à des dispositifs de commutation électrique, tels que des interrupteurs pilotables à distance, pour sélectivement déconnecter ou reconnecter une ou plusieurs des charges électriques, voire toutes les charges électriques. Les dispositifs de commutation électrique peuvent être des relais, ou des contacteurs, ou des interrupteurs de puissance à base de semi-conducteurs, ou tout autre appareil équivalent. Le dispositif électronique de commande 100 peut également communiquer avec une ou plusieurs des charges électriques principales 80,82,42 et 44 en vue de moduler la consommation électrique et/ou la production électrique de ces sources ou de ces charges (lorsqu'elles le permettent ou sont réversibles). Cette communication est, par exemple, assurée par des dispositifs de communication tels qu'un bus de communication, par exemple de technologie « ModBus » ou « Open Charge Point Protocol » (OCPP) ou équivalent.

Notamment, le dispositif de commande 100 est configuré pour, en fonction du courant mesuré, gérer des paramètres d'alimentation d'au moins une partie des charges électriques, afin de réduire le courant électrique consommé par ces charges et/ou gérer des paramètres de fonctionnement afin de respecter le seuil de courant imposé par un disjoncteur principal connecté entre l'installation électrique et le réseau de distribution électrique.

Par exemple, il peut s'agir de déconnecter ou reconnecter automatiquement une ou plusieurs des charges électriques en fonction du courant mesuré dans le cadre d'une action de délestage, pour ajuster la puissance électrique consommée par les charges électriques en fonction de la puissance électrique souscrite auprès du gestionnaire du réseau 32 (sur laquelle est calé le seuil du disjoncteur principal 11) et de la puissance électrique que la source secondaire 34 est en mesure de fournir.

De préférence, le dispositif 30 comporte des dispositifs de mesure 33, 35 capables de mesurer la puissance électrique fournie par les sources électriques (notamment par le réseau 32 et par la source secondaire 34) et/ou la puissance électrique transitant par les différentes branches du dispositif de raccordement 36. Il peut, par exemple, s'agir d'un ou de plusieurs capteurs de courant et/ou capteurs de tension et/ou Wattmètres (W) et/ou tout dispositif de mesure équivalent ou approprié. Par exemple, un premier dispositif de mesure 33 est associé au réseau 32 tandis qu'un deuxième dispositif de mesure 35 est associé à la source 34.

De façon générale, comme illustré par le schéma 300, le dispositif électronique de commande 100 est configuré pour :
- déterminer, au moyen de capteurs permettant de déterminer le courant électrique circulant dans l'installation (bloc 302), et
- gérer des paramètres d'alimentation d'au moins une partie des charges électriques et/ou déconnecter ou reconnecter automatiquement une ou plusieurs des charges électriques en fonction du courant mesuré. Cela correspond à des étapes de délestage (bloc 304) et de rétablissement (bloc 306) des charges électriques concernées.

Ce procédé permet de surveiller et gérer la consommation des charges électriques en fonction du contrat souscrit auprès du gestionnaire du réseau 32 , notamment pour que le courant fourni par le réseau ne dépasse pas le seuil fixé par l'abonnement (par exemple, 40 A ou 60 A) car cela pourrait conduire à un déclenchement du disjoncteur principal 11, notamment pour détecter si le courant fourni par le réseau 32 dépasse le seuil fixé par l'abonnement (I_Grid par rapport à I_seuil de l'élément 11).

Dans l'exemple illustré, à l'étape 302, le dispositif de commande 100 mesure des grandeurs électriques au moyen des capteurs et des dispositifs de mesure et détermine (directement et/ou par des calculs) des valeurs de courants électriques et/ou des valeurs de puissance électrique en un ou plusieurs emplacements W de l'installation de distribution.

Ensuite, le dispositif de commande 100 compare les grandeurs mesurées 310 avec des grandeurs de référence, pouvant être des seuils de protection dont le dépassement indique l'apparition d'une surintensité.

Dans certains exemples, la comparaison peut être réalisée en calculant un rapport entre des grandeurs électriques (une grandeur électrique mesurée et une limite prédéfinie) et comparer ce rapport à une valeur numérique prédéfinie.

Par exemple, on utilise un indicateur nommé « rapport de courant » qui est défini comme égal au rapport du courant circulant en un point de l'installation (dans le répartiteur 36) divisé par un seuil de courant, tel que le seuil de protection précédemment défini (par exemple égal à 96 A ou à 120 A).

En variante, on pourrait utiliser un rapport de puissance défini comme égal à la puissance électrique délivrée par le réseau 32 divisée par une limite de puissance électrique prédéfinie (ces puissances pouvant être des puissances instantanées, ou des puissances moyennées sur une même durée)

Par exemple, au moins l'un desdits rapports est calculé lors de l'étape 312, puis à l'étape 314, le dispositif de commande 100 détermine si une surintensité a été identifiée à partir de la valeur du ou des rapports calculés.

Si une surintensité a été identifiée, alors au bloc 304 le dispositif de commande 100 met en oeuvre un procédé de délestage pour interrompre le fonctionnement d'au moins une des charges principales, afin de réduire la consommation électrique et ainsi adapter la consommation en fonction de la puissance disponible sur le réseau 32 (en fonction du contrat de fourniture souscrit, qui limite la puissance ou le courant disponible) et la puissance disponible sur les sources secondaires, notamment sur les sources intermittentes telles que les générateurs photovoltaïques lorsque la source secondaire 34 comprend de tels générateurs.

Par exemple, lors d'une étape 320, le dispositif de commande 100 détermine automatiquement quelles charges peuvent être délestées. Par exemple, une liste des charges électriques gérées par le système et de leurs caractéristiques est au préalable enregistré en mémoire.

Cette détermination est par exemple mise en oeuvre suivant une loi de commande prédéfinie, par exemple au moyen d'algorithmes de gestion de délestage connus.

En pratique, selon la nature des charges électrique présentes, il est possible de réduire leur consommation graduellement sans interrompre totalement la charge électrique (« dimmable charges » en anglais) ou bien d'interrompre complètement la charge (et donc d'arrêter leur consommation) en les déconnectant ou en les arrêtant.

Un exemple de charge réglable dont la consommation peut être variée graduellement est un équipement de chauffage ou de climatisation dont la température de consigne peut être modifiée pour chauffer moins (ou moins refroidir). Il peut aussi s'agir d'une borne de chargement de véhicule électrique dont le débit de recharge est diminué.

Lorsqu'applicable, cette régulation est réalisée au moyen du dispositif de régulation intégré à la charge électrique correspondante.

Ainsi, suite à l'étape 320, le dispositif de commande 100 envoie automatiquement des ordres pour réduire la consommation d'une ou de plusieurs charges (étape 322) et/ou des ordres pour déconnecter une charge (étape 324).

Selon la nature de la charge et sa connexion au système 30, l'ordre de déconnexion est envoyé directement à la charge pour qu'elle s'interrompe elle-même, ou à un dispositif de commutation situé entre le répartiteur 36 et une entrée d'alimentation de la charge, ainsi que cela sera expliqué plus en détail au travers d'exemples présentés ci-après.

Ensuite, lors de l'étape 306, la ou les charges sont rétablies, par exemple une fois que la condition de défaut a disparu et/ou à l'expiration d'un délai de temporisation prédéfini.

Par exemple, lors de l'étape 330, le dispositif de commande 100 détermine automatiquement laquelle ou lesquelles des charges précédemment ciblées peuvent être rétablies. Cette détermination peut être réalisée en fonction de caractéristiques connues desdites charges, suivant une loi de commande prédéfinie, à l'image du procédé de l'étape 320.

Ainsi, suite à l'étape 330, le dispositif de commande 100 envoie automatiquement des ordres pour rétablir graduellement la consommation d'une ou de plusieurs charges variables (étape 334) et/ou des ordres pour reconnecter une charge (étape 336) après un délai de temporisation (étape 332).

L'étape 302 est ensuite répétée.

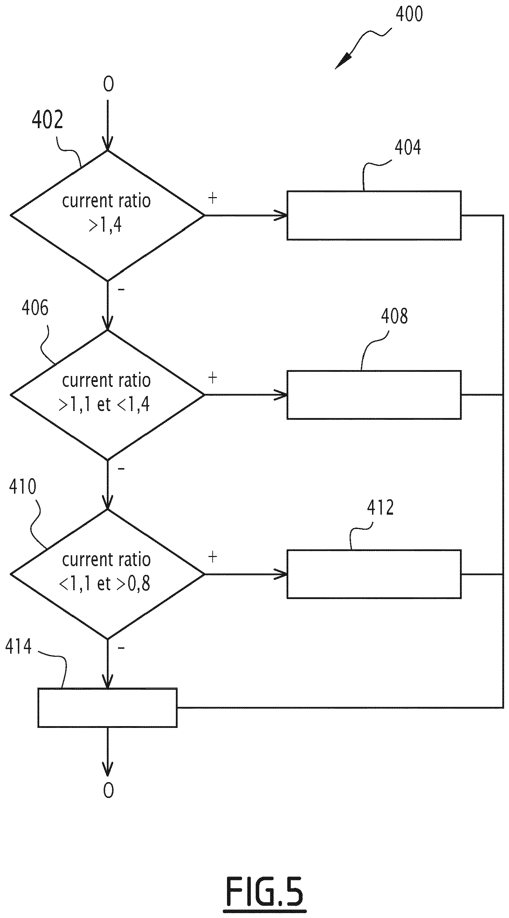

La figure 5 représente un exemple de mise en oeuvre simplifiée des étapes de délestage d'une ou de plusieurs charges électriques du système du procédé de la figure 3.

Le procédé 400, qui détaille un exemple de fonctionnement de l'étape mise en oeuvre au bloc 302 susmentionné, débute après que les rapports précédemment décrits ont été calculés.

À l'étape 402, le rapport de courant (noté « current_ratio » sur la figure 5) est comparé à un premier seuil (ici choisi égal à 1,4 bien que d'autres exemples soient possibles). Si le rapport calculé est supérieur au premier seuil, alors la ou les charges concernées sont immédiatement interrompues (étape 404 puis étape 304).

Dans le cas contraire, le rapport de courant (current_ratio) est comparé (étape 406) à un deuxième seuil (ici choisi égal à 1,1 bien que d'autres exemples soient possibles). Si le rapport calculé est supérieur au deuxième seuil, tout en étant inférieur au premier seuil, alors la ou les charges concernées sont interrompues après un premier délai de temporisation, par exemple égal à 20 secondes (étape 408 puis étape 304).

Dans le cas où aucune des deux conditions n'est remplie, alors à l'étape 410 le rapport de courant (noté « current ratio » sur la figure 5) est comparé à des seuils prédéfinis (ici égaux à 0,8 et 1,1 d'autres exemples étant néanmoins possibles). Si le rapport calculé est compris entre le premier seuil et le deuxième seuil alors la ou les charges concernées sont interrompues après un deuxième délai de temporisation, par exemple égal à 300 secondes (étape 412 puis étape 304).

Le procédé prend fin à l'étape 414.

En variante, les valeurs des seuils des rapports de courant (première et deuxième valeurs de seuil) pourraient prendre des valeurs différentes. Ces valeurs de seuil sont de préférence choisies en fonction des propriétés de l'élément de protection 11 de l'installation et du niveau de protection électrique souhaité. Il en va de même pour les valeurs de temporisation.

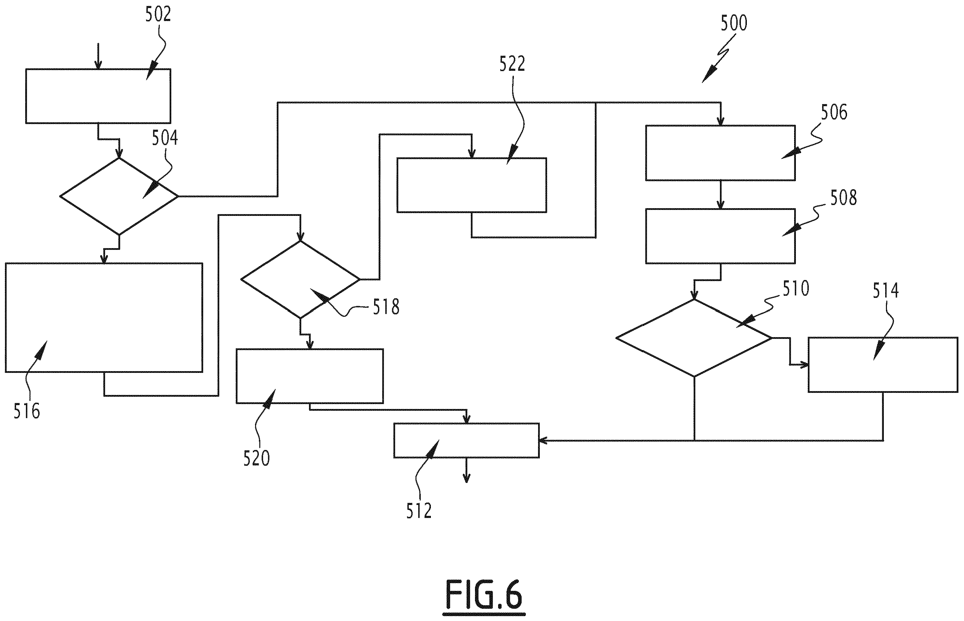

La figure 6 détaille un exemple de fonctionnement (procédé 500) de l'étape mise en oeuvre au bloc 304 susmentionné pour commander le délestage d'une ou de plusieurs charges électriques.

Dans cet exemple, le délestage agit en priorité sur certaines charges plutôt que d'autres (en particulier les charges facilement modulables ou déconnectables) en fonction de leur nature. Par exemple, on vise d'abord à déconnecter ou à limiter la charge du véhicule électrique, puis ensuite celle d'une charge telle que le chauffe-eau ou la climatisation. Le choix du chauffe-eau est ici justifié par le fait que l'arrêt provisoire du chauffe-eau ne dégradera pas le confort des utilisateurs puisqu'il existe une réserve d'eau chaude dans laquelle l'utilisateur peut puiser même lorsque les moyens de chauffage du chauffe-eau sont temporairement désactivés.

Le procédé débute à l'étape 502, une fois qu'un ordre de délestage a été émis et que, le cas échéant, la durée correspondant à la temporisation s'est écoulée.

À l'étape 504, le dispositif électronique de commande 100 vérifie si un véhicule électrique est connecté à la borne de chargement et vérifie si les batteries de ce véhicule ne sont pas pleines.

Si aucun véhicule n'est connecté ou si les batteries sont pleines, alors, dans une étape 506, le chauffe-eau est interrompu temporairement. Par exemple, le dispositif de commande ordonne la déconnexion du chauffe-eau connecté au coffret secondaire 40, puis déclenche un compteur de temps, pendant laquelle l'alimentation du chauffe-eau restera interrompue.

Un nouveau rapport de courant est calculé lors de l'étape 508, puis une comparaison avec le seuil limite est réalisée lors d'une étape 510.

Par exemple, si le procédé complet est mis en oeuvre pour déterminer si le courant consommé est dans les limites des paramètres de l'abonnement souscrit auprès du gestionnaire du réseau 32, alors l'étape 510 peut comporter la comparaison du ratio avec une première valeur spécifiquement choisie en fonction du seuil défini dans le contrat.

Si la comparaison montre que le nouveau ratio est inférieur au seuil limite, alors le procédé 500 prend fin à l'étape 512. Un message peut être émis pour indiquer qu'un délestage est actif.

Dans le cas où la comparaison montre que le nouveau ratio est malgré tout supérieur au seuil limite, alors le dispositif électronique de commande déconnecte une autre charge électrique.

Par exemple, lors d'une étape 514, on déconnecte la pompe à chaleur du tableau secondaire 40 et on impose une temporisation pendant laquelle cette charge ne sera pas réalimentée. Le procédé peut alors se terminer directement à l'étape 512.

Dans le cas où, à l'issue de l'étape 504, un véhicule a été identifié comme connecté à la borne de chargement et dont les batteries ne sont pas remplies, indiquant que le véhicule est potentiellement en cours de charge, alors, dans une étape 516, on calcule une nouvelle consigne de charge pour le véhicule électrique, par exemple pour réduire la puissance électrique consommée.

Lors d'une étape 518, le dispositif de commande vérifie si la consigne de charge de la station de charge est négative, indiquant que le courant à réduire est supérieur à la seule demande du véhicule électrique. Si tel est le cas, alors lors d'une étape 522 une nouvelle consigne de charge est choisie égale à zéro pour désactiver la borne de charge et le procédé passe à l'étape 506 précédemment décrite, pour déconnecter une autre charge.

Dans le cas où la consigne de charge de la station de charge est positive ou nulle, alors la nouvelle consigne de charge calculée est assignée à la borne de chargement qui sera transmise au véhicule électrique lors d'une étape 520. Le procédé prend ensuite fin à l'étape 512.

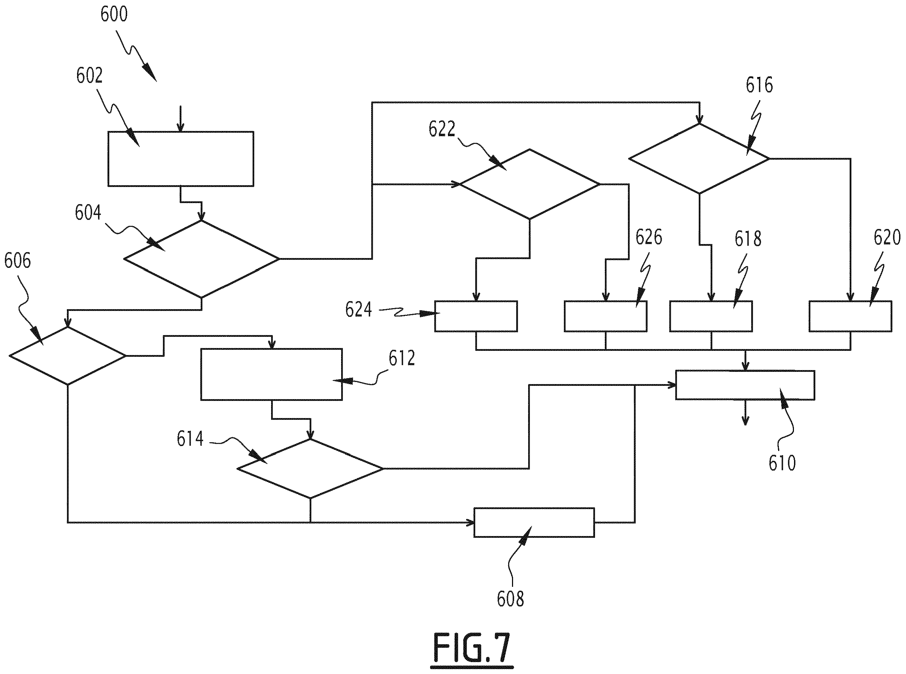

La figure 7 détaille un exemple (procédé 600) de fonctionnement de l'étape mise en oeuvre au bloc 306 susmentionné pour réactiver une ou plusieurs charges électriques une fois que le délestage doit prendre fin.

Le procédé débute à l'étape 602, une fois qu'un ordre de mettre fin au délestage a été émis.

À l'étape 604, le dispositif électronique de commande vérifie si au moins l'un ou l'autre du chauffe-eau ou de la pompe à chaleur (ou climatiseur) est à l'arrêt, suite au délestage.

Si aucune de ces charges n'est identifiée comme étant arrêtée, alors, dans une étape 606, le dispositif 100 vérifie si un véhicule électrique est connecté à la borne de chargement et vérifie si les batteries de ce véhicule ne sont pas pleines.

Si aucun véhicule n'est connecté ou si les batteries sont pleines, alors, dans une étape 608, un message est envoyé (ou un registre est mis à jour) pour indiquer que le délestage est terminé. Le procédé prend ensuite fin lors d'une étape 610.

Dans le cas où, à l'issue de l'étape 606, un véhicule a été identifié comme connecté à la borne de chargement et dont les batteries ne sont pas remplies, indiquant que le véhicule est potentiellement en cours de charge, alors, dans une étape 612, le dispositif de commande calcule une nouvelle consigne de charge pour la borne de chargement, par exemple pour augmenter la puissance électrique consommée par le véhicule électrique.

Lors d'une étape 614, le dispositif de commande 100 vérifie si la nouvelle consigne de charge calculée est supérieure à la consigne maximale. Si tel est le cas, alors le procédé passe à l'étape 608 et prend fin à l'étape 610.

Dans le cas où la nouvelle consigne de charge calculée est inférieure à la consigne maximale, alors on passe directement à l'étape 610.

De retour à l'étape 604, si le dispositif de commande 100 identifie qu'au moins une des autres charges, telles que le chauffe-eau 80 ou la pompe à chaleur du climatiseur 82, est déjà à l'arrêt, alors, une ou plusieurs vérifications sont mises en place.

Dans une étape 616, le dispositif 100 vérifie si la temporisation imposée à la pompe à chaleur 82 (ou climatiseur) connecté au tableau secondaire 40 est arrivée à son terme. Si tel est le cas, alors, dans une étape 618, la pompe à chaleur 82 (ou climatiseur) est reconnectée. Dans le cas contraire, lors d'une étape 620, la pompe à chaleur 82 (ou climatiseur) reste déconnectée. Le procédé prend fin à l'étape 610.

En parallèle, dans une étape 622, le dispositif de commande vérifie si la temporisation imposée au chauffe-eau est arrivée à son terme. Si tel est le cas, alors, dans une étape 624, la charge correspondante est reconnectée pour réalimenter le chauffe-eau. Dans le cas contraire, lors d'une étape 626, la charge reste déconnectée. Le procédé prend fin à l'étape 610.

Toutefois, en variante, ces étapes et ce procédé pourraient être entièrement omis, de même que le dispositif électronique de commande, ainsi que lesdits moyens de mesure et de pilotage (les dispositifs de commutation électrique pilotés par le dispositif électronique de commande).

Les modes de réalisation et les variantes envisagés ci-dessus peuvent être combinés entre eux pour donner naissance à de nouveaux modes de réalisation.

## Revendications

1. Système de distribution électrique (30) pour distribuer des courants électriques entre un réseau de distribution électrique et une installation domestique de distribution, dans lequel le système de distribution électrique comporte :
- un appareil de commutation électrique multi sources (38) configuré pour commuter entre deux états autorisant ou empêchant respectivement la circulation de courants électriques dans deux chemins de conduction électrique comportant chacun une pluralité de conducteurs électriques (L, N) ;
- un dispositif de raccordement électrique (36) raccordé en sortie de l'appareil de commutation électrique, le dispositif de raccordement étant configuré pour prolonger les deux chemins de conduction électrique en sortie de l'appareil de commutation ;
dans lequel l'appareil de commutation électrique (38) est configuré pour connecter, sur une première entrée, un premier des deux chemins de conduction électrique à un réseau de distribution électrique (32), l'appareil de commutation électrique étant configuré pour connecter, sur sa deuxième entrée, le deuxième des deux chemins de conduction électrique à une source électrique auxiliaire (34) ;
dans lequel le dispositif de raccordement (36) est configuré pour connecter chaque chemin de conduction électrique à une ou plusieurs charges électriques (40, 42, 44) en sortie de l'appareil de commutation électrique ;
le système de distribution électrique étant **caractérisé en ce que** le dispositif de raccordement électrique (36) comporte un point d'interconnexion dans lequel les conducteurs électriques (L, N) correspondants de chaque chemin de conduction électrique sont connectés entre eux, l'appareil de commutation électrique multi-sources (38) formant un point de déconnexion unique capable de déconnecter simultanément du reste du réseau de distribution électrique (30) les sources électriques connectées à la première entrée et à la deuxième entrée.

2. Système selon la revendication 1, dans lequel le dispositif de raccordement électrique (36) forme un pont en H pour chaque phase électrique ou ligne de neutre.

3. Système selon l'une quelconque des revendications précédentes, dans lequel le dispositif de raccordement électrique (36) comporte des conducteurs de connexion en un matériau électriquement conducteur, chaque conducteur de connexion étant associée à une phase électrique ou à une ligne de neutre.

4. Système selon l'une quelconque des revendications précédentes, dans lequel, le dispositif de raccordement électrique (36) comporte, pour chaque phase électrique ou ligne de neutre, un ensemble de conducteurs électriques comportant :
- au moins un premier conducteur pour former le premier chemin de conduction électrique associé à cette phase ou ligne de neutre,
- au moins un deuxième conducteur pour former le deuxième chemin de conduction électrique associé à cette phase ou ligne de neutre, et
- un point d'interconnexion associé à cette phase ou ligne de neutre qui raccorde le au moins un premier conducteur audit au moins un deuxième conducteur de cette phase ou ligne de neutre.

5. Système selon l'une quelconque des revendications précédentes, dans lequel chaque point d'interconnexion du dispositif de raccordement électrique (36) a un calibre de 63 Ampères.

6. Système selon l'une quelconque des revendications 1 à 4, dans lequel chaque point d'interconnexion du dispositif de raccordement électrique (36) a un calibre de 125 Ampères.

7. Système selon l'une quelconque des revendications précédentes, dans lequel chacun du premier chemin de conduction électrique et du deuxième chemin de conduction électrique du dispositif de raccordement électrique (36) a un calibre de 63 Ampères.

8. Système selon l'une quelconque des revendications précédentes, dans lequel une partie des charges électriques est apte à être connectée au premier chemin de conduction électrique et une autre partie des charges électriques (42, 44) est apte à être connectée au deuxième chemin de conduction électrique.

9. Système selon l'une quelconque des revendications précédentes, dans lequel la source électrique auxiliaire (34) comporte un ou plusieurs générateurs photovoltaïques.

10. Installation de distribution électrique (1), notamment à usage domestique, comportant un système de distribution électrique (30) selon l'une quelconque des revendications précédentes.

## Patentansprüche

1. Elektrisches Verteilungssystem (30) zum Verteilen von elektrischen Strömen zwischen einem elektrischen Verteilungsnetz und einer häuslichen Verteilungsinstallation, wobei das elektrische Verteilungssystem Folgendes umfasst:
- ein elektrisches Mehrquellen-Schaltgerät (38), das konfiguriert ist, um zwischen zwei Zuständen zu schalten, die den Fluss von elektrischen Strömen in zwei elektrischen Leitungswegen, die jeweils eine Vielzahl von elektrischen Leitern (L, N) umfassen, zulassen bzw. verhindern;
- eine elektrische Anschlussvorrichtung (36), die an dem Ausgang des elektrischen Schaltgeräts angeschlossen ist, wobei die Anschlussvorrichtung konfiguriert ist, um die zwei elektrischen Leitungswege am Ausgang des Schaltgeräts zu verlängern;
wobei das elektrische Schaltgerät (38) konfiguriert ist, um an einem ersten Eingang einen ersten der zwei elektrischen Leitungswege mit einem elektrischen Verteilungsnetz (32) zu verbinden, wobei das elektrische Schaltgerät konfiguriert ist, um an seinem zweiten Eingang den zweiten der zwei elektrischen Leitungswege mit einer Hilfsstromquelle (34) zu verbinden;
wobei die Anschlussvorrichtung (36) konfiguriert ist, um jeden elektrischen Leitungsweg mit einer oder mehreren elektrischen Lasten (40, 42, 44) am Ausgang des elektrischen Schaltgeräts zu verbinden;
wobei das elektrische Verteilungssystem **dadurch gekennzeichnet ist, dass** die elektrische Anschlussvorrichtung (36) einen Verbindungspunkt umfasst, in dem die entsprechenden elektrischen Leiter (L, N) von jedem elektrischen Leitungsweg miteinander verbunden sind, wobei das elektrische Mehrquellen-Schaltgerät (38) einen einzelnen Trennungspunkt bildet, der in der Lage ist, die mit dem ersten Eingang und dem zweiten Eingang verbundenen elektrischen Quellen gleichzeitig vom Rest des elektrischen Verteilungssystems (30) zu trennen.

2. System nach Anspruch 1, wobei die elektrische Anschlussvorrichtung (36) eine H-Brücke für jede elektrische Phase oder jeden Nullleiter bildet.

3. System nach einem der vorherigen Ansprüche, wobei die elektrische Anschlussvorrichtung (36) Verbindungsleiter aus einem elektrisch leitenden Material umfasst, wobei jeder Verbindungsleiter mit einer elektrischen Phase oder einem Nullleiter assoziiert ist.

4. System nach einem der vorherigen Ansprüche, wobei die elektrische Anschlussvorrichtung (36) für jede elektrische Phase oder jeden Nullleiter eine Gruppe von elektrischen Leitern umfasst, umfassend:
- mindestens einen ersten Leiter, um den ersten elektrischen Leitungsweg zu bilden, der mit dieser Phase oder diesem Nullleiter assoziiert ist,
- mindestens einen zweiten Leiter, um den mit dieser Phase oder diesem Nullleiter assoziierten zweiten elektrischen Leitungsweg zu bilden, und
- einen Verbindungspunkt, der mit dieser Phase oder diesem Nullleiter assoziiert ist, der den mindestens einen ersten Leiter mit dem mindestens einen zweiten Leiter dieser Phase oder dieses Nullleiters verbindet.

5. System nach einem der vorherigen Ansprüche, wobei jeder Verbindungspunkt der elektrischen Anschlussvorrichtung (36) eine Stromstärke von 63 Ampere aufweist.

6. System nach einem der Ansprüche 1 bis 4, wobei jeder Verbindungspunkt der elektrischen Anschlussvorrichtung (36) eine Stromstärke von 125 Ampere aufweist.

7. System nach einem der vorherigen Ansprüche, wobei jeder von dem ersten elektrischen Leitungsweg und dem zweiten elektrischen Leitungsweg der elektrischen Anschlussvorrichtung (36) eine Stromstärke von 63 Ampere aufweist.

8. System nach einem der vorherigen Ansprüche, wobei ein Teil der elektrischen Lasten geeignet ist, um mit dem ersten elektrischen Leitungsweg verbunden zu werden und ein anderer Teil der elektrischen Lasten (42, 44) dazu geeignet ist, mit dem zweiten elektrischen Leitungsweg verbunden zu werden.

9. System nach einem der vorherigen Ansprüche, wobei die elektrische Hilfsquelle (34) einen oder mehrere photovoltaische Generatoren umfasst.

10. Elektrische Verteilungsinstallation (1), insbesondere für häuslichen Gebrauch, umfassend ein elektrisches Verteilungssystem (30) nach einem der vorherigen Ansprüche.

## Claims

1. An electrical distribution system (30) for distributing electrical currents between an electrical distribution network and a domestic distribution installation, wherein the electrical distribution system comprises:
- a multi-source electrical switching device (38) configured to switch between two states respectively allowing or preventing the flow of electrical currents in two electrical conduction paths each comprising a plurality of electrical conductors (L, N);
- an electrical connection device (36) connected to the output of the electrical switching device, the connection device being configured to extend the two electrical conduction paths at the output of the switching device;
in which the electrical switching apparatus (38) is configured to connect, at a first input, a first of the two electrical conduction paths to an electrical distribution network (32), the electrical switching device being configured to connect, at its second input, the second of the two electrical conduction paths to an auxiliary electrical source (34);
wherein the connection device (36) is configured to connect each electrical conduction path to one or more electrical loads (40, 42, 44) output from the electrical switching device;
the electrical distribution system being **characterized in that** the electrical connecting device (36) has an interconnection point in which the corresponding electrical conductors (L, N) of each electrical conduction path are connected to each other, the multi-source electrical switchgear (38) forming a single disconnect point capable of simultaneously disconnecting from the rest of the electrical distribution network (30) the electrical sources connected at the first and second inputs.

2. A system as claimed in claim 1, in which the electrical connection device (36) forms an H-bridge for each electrical phase or neutral line.

3. A system according to any one of the preceding claims, in which the electrical connection device (36) comprises connection conductors made of an electrically conductive material, each connection conductor being associated with an electrical phase or a neutral line.

4. A system according to any one of the preceding claims, in which the electrical connection device (36) comprises, for each electrical phase or neutral line, a set of electrical conductors comprising:
- at least one first conductor to form the first electrical conduction path associated with this phase or neutral line,
- at least one second conductor to form the second electrical conduction path associated with this phase or neutral line, and
- an interconnection point associated with this phase or neutral line which connects the at least one first conductor to the at least one second conductor of this phase or neutral line.

5. A system according to any one of the preceding claims, wherein each interconnection point of the electrical connection device (36) has a rating of 63 Amperes.

6. A system according to any one of claims 1 to 4, wherein each interconnection point of the electrical connection device (36) has a rating of 125 Amps.

7. A system according to any one of the preceding claims, wherein each of the first electrical conduction path and the second electrical conduction path of the electrical connection device (36) has a rating of 63 Amperes.

8. System according to any of the previous claims, in which a portion of the electrical charges is capable of being connected to the first electrical conduction path and another portion of the electrical charges (42, 44) is capable of being connected to the second electrical conduction path.

9. A system according to any one of the preceding claims, wherein the auxiliary electrical source (34) comprises one or more photovoltaic generators.

10. Electrical distribution installation (1), in particular for domestic use, comprising an electrical distribution system (30) according to any one of the preceding claims.
